# EUROPEAN PATENT APPLICATION

(11) **EP 4 675 409 A1**
(43) Date of publication of application: **07.01.2026**
(21) Application number: 24774758.7
(22) Date of filing: 12.03.2024
(51) Int. Cl.: G06F 3/0481, G06F 1/26, H04M 1/72451, G01R 31/367

(54) **MOBILE TERMINAL DEVICE, PROPOSAL DISPLAY METHOD, AND PROGRAM**

(30) Priority: 20.03.2023 JP 2023044354
(71) Applicant: Sony Group Corporation, Tokyo 108-0075 (JP)
(72) Inventor: BENISE, Kimitaka, Tokyo 108-0075 (JP); SUZUKI, Kuniharu, Tokyo 108-0075 (JP); TANAKA, Go, Tokyo 108-0075 (JP); FURUKAWA, Hikaru, Tokyo 108-0075 (JP); AKASAWA, Hidetoshi, Tokyo 108-0075 (JP); FURUYA, Tatsuya, Tokyo 108-0075 (JP); CHEN, Pohsiang, Tokyo 108-0075 (JP); FUJIMOTO, Yuki, Tokyo 108-0075 (JP)
(74) Representative: D Young & Co LLP
(86) International application number: PCT/JP2024/009484
(87) International publication number: WO 2024/195619

(57) **Abstract**

In a mobile terminal device, a processor causes the display unit to display a first display indicating a use having caused damage to the battery, causes the display unit to display a second display indicating a cause of the damage given to the battery, when the first display is selected, and causes the display unit to display a third display indicating a proposal of a setting for reducing the damage given to the battery, when the second display is selected.

## Description

### Field

The present disclosure relates to a mobile terminal device, a proposal display method, and a program.

### Background

Some mobile terminal devices mounted with batteries enable users to check use histories of the batteries, current performances of the batteries, and various setting contents related to the batteries.

### Citation List

### Patent Literature

Patent Literature 1: JP 2019-063554 A

### Summary

### Technical Problem

However, it is difficult for many users to recognize what kind of use causes damage to the battery.

Therefore, the present disclosure proposes a technique enables to suppress deterioration of a battery mounted on a mobile terminal device.

### Solution to Problem

A mobile terminal device of the present disclosure includes a battery, a display unit, and a processor. The processor causes the display unit to display a first display indicating a use having caused damage to the battery. The processor causes the display unit to display a second display indicating a cause of the damage given to the battery, when the first display is selected. And the processor causes the display unit to display a third display indicating a proposal of a setting for reducing the damage given to the battery, when the second display is selected.

### Brief Description of Drawings

FIG. 1 is a diagram illustrating an exemplary configuration of a mobile terminal device according to a first embodiment of the present disclosure.
FIG. 2 is a diagram illustrating an example of a battery use history screen according to the first embodiment of the present disclosure.
FIG. 3 is a diagram illustrating an example of a battery state transition screen according to the first embodiment of the present disclosure.
FIG. 4 is a diagram illustrating an example of a notification setting screen according to the first embodiment of the present disclosure.
FIG. 5 is a diagram illustrating an example of a notification setting screen according to the first embodiment of the present disclosure.
FIG. 6 is a diagram illustrating an example of a notification setting screen according to the first embodiment of the present disclosure.
FIG. 7 is a diagram illustrating an example of a charge setting screen according to the first embodiment of the present disclosure.
FIG. 8 is a diagram illustrating an example of a charge setting screen according to the first embodiment of the present disclosure.
FIG. 9 is a diagram illustrating an example of a charge setting screen according to the first embodiment of the present disclosure.

### Description of Embodiments

Embodiments of the present disclosure will be described below in detail with reference to the drawings. Note that in the following embodiments, the same portions or the same processes are denoted by the same reference numerals, and the descriptions thereof will not be repeated in some cases.

Furthermore, the technique of the present disclosure will be described in the order of items shown below.

### [First Embodiment]

### <Configuration of mobile terminal device>

### <Display on display unit>

### [Second Embodiment]

### [Effects of disclosed techniques]

### [First Embodiment]

### <Configuration of mobile terminal device>

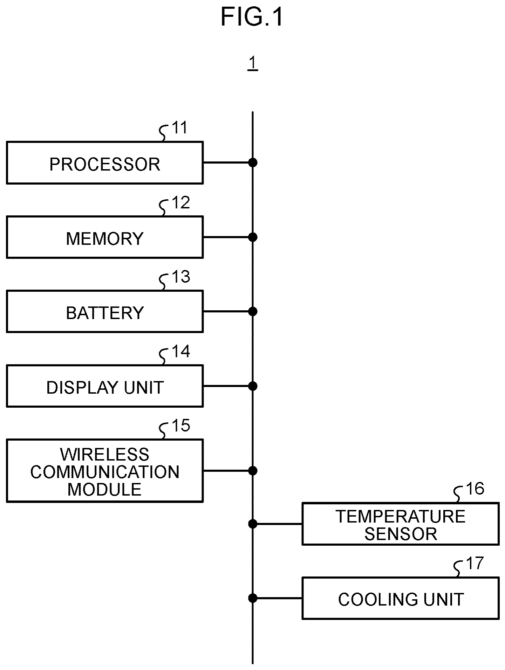

FIG. 1 is a diagram illustrating an exemplary configuration of a mobile terminal device according to a first embodiment of the present disclosure. In FIG. 1, the mobile terminal device 1 includes a processor 11, a memory 12, a battery 13, a display unit 14, a wireless communication module 15, a temperature sensor 16, and a cooling unit 17.

An example of the mobile terminal device 1 includes a smart device such as a smartphone or a tablet terminal, a laptop personal computer, or the like. An example of the processor 11 includes a central processing unit (CPU), digital signal processor (DSP), field programmable gate array (FPGA), or the like. An example of the memory 12 includes a random access memory (RAM), a read only memory (ROM), or a flash memory. An example of the battery 13 includes a lithium-ion battery. An example of the display unit 14 includes a touch screen or a display. An example of the display includes a liquid crystal display (LCD).

When a temperature of the mobile terminal device 1 (hereinafter, often referred to as "terminal temperature") rises, a temperature of the battery 13 (hereinafter, often referred to as "battery temperature") also rises, and the deterioration of the battery 13 further proceeds. Therefore, the temperature sensor 16 detects the terminal temperature.

The cooling unit 17 cools the mobile terminal device 1. The cooling unit 17 is formed by using, for example, a piezoelectric element.

### <Display on display unit>

Hereinafter, an example of using a touch screen for the display unit 14 will be described.

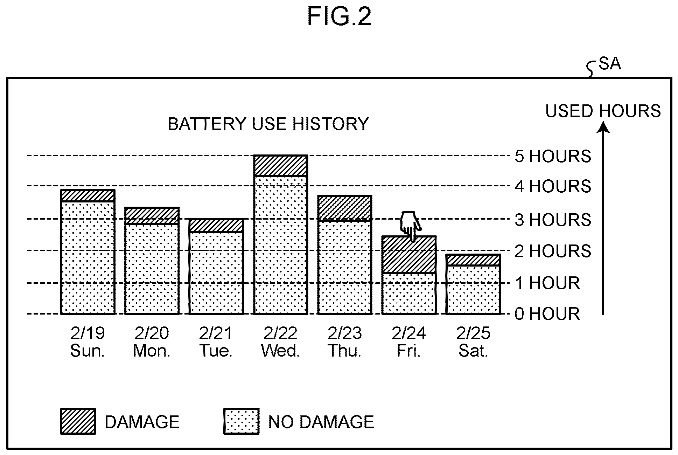

The processor 11 causes the display unit 14 to display a screen (hereinafter, referred to as "battery use history screen") SA indicating a use history of the battery 13 (hereinafter, often referred to as "battery use history"), as illustrated in FIG. 2, in response to a predetermined operation of the user on the mobile terminal device 1. FIG. 2 is a diagram illustrating an example of the battery use history screen according to the first embodiment of the present disclosure.

As illustrated in FIG. 2, the battery use history screen SA includes display indicating a use having caused damage to the battery 13 (hereinafter, often referred to as "display of damage") and display indicating a use without causing damage to the battery 13 (hereinafter, often referred to as "display of no damage"), and, for example, a pair of the display of damage and the display of no damage per day is displayed on the basis of used hours, in the form of a bar graph, over a plurality of days. FIG. 2 illustrates an example of the battery use history for one week from Sunday, February 19th to Saturday, February 25th.

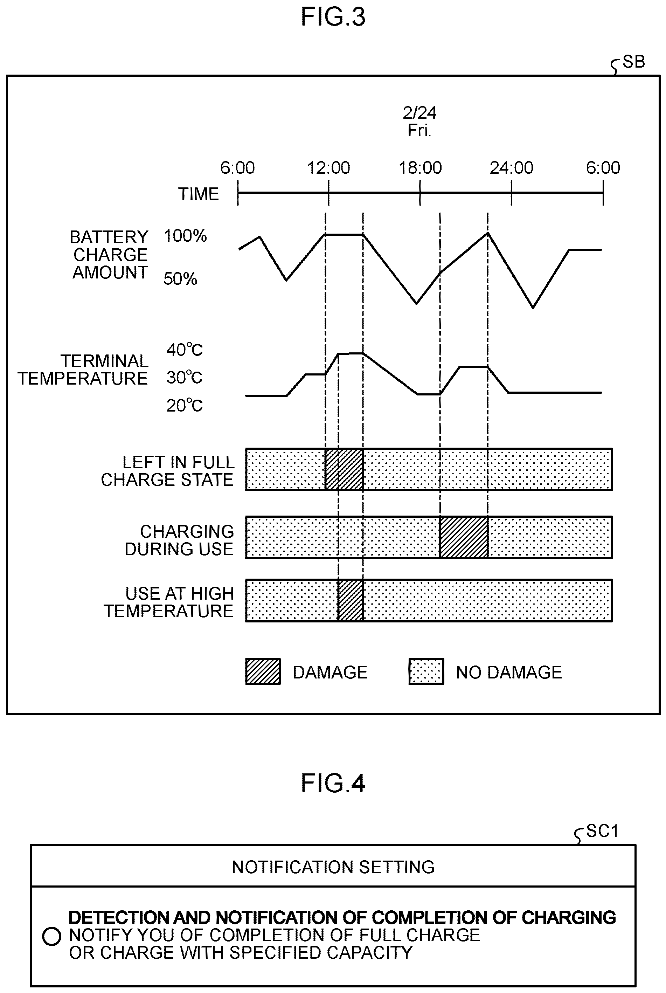

Next, for example, when detecting that the display of damage on Friday, February 24th is touched on the battery use history screen SA, the processor 11 performs transition of screens to be displayed on the display unit 14, from the battery use history screen SA to a screen SB (hereinafter, often referred to as "battery state transition screen") showing the transition of the state of the battery 13 (hereinafter, often referred to as "battery state transition") as illustrated in FIG. 3. FIG. 3 is a diagram illustrating an example of the battery state transition screen according to the first embodiment of the present disclosure.

As illustrated in FIG. 3, when the display of damage on Friday, February 24 is touched on the battery use history screen SA, the transition of the state of the battery 13 over 24 hours on Friday, February 24 is displayed on the battery state transition screen SB being a transition destination. In addition, the battery state transition screen SB includes a display (hereinafter, often referred to as a "damage cause display") indicating a cause of the damage (hereinafter, often referred to as a "damage cause") given to the battery 13. For example, as illustrated in FIG. 3, examples of the damage cause include a cause (hereinafter, often referred to as "first cause") that the battery 13 has been left in a full charge state (hereinafter, often referred to as "left in full charge"), a cause (hereinafter, often referred to as "second cause") that the battery 13 has been charged during use of the mobile terminal device 1 (hereinafter, often referred to as "charging during use"), and a cause (hereinafter, often referred to as "third cause") that the mobile terminal device 1 has been used while the terminal temperature is equal to or larger than a threshold THA (hereinafter, often referred to as "use at high temperature"). The processor 11 causes the display unit 14 to display each of a display indicating the first cause (hereinafter, often referred to as "first cause display"), a display indicating the second cause (hereinafter, often referred to as "second cause display"), and a display indicating the third cause (hereinafter, often referred to as "third cause display"), in association with a time slot in which the battery 13 is damaged, on the battery state transition screen SB.

Next, for example, when detecting that the first cause display is touched on the battery state transition screen SB, the processor 11 performs transition of screens to be displayed on the display unit 14, from the battery state transition screen SB to transition to a notification setting screen SC1 as illustrated in FIG. 4. FIG. 4 is a diagram illustrating an example of the notification setting screen according to the first embodiment of the present disclosure. The notification setting screen SC1 illustrated in FIG. 4 includes a display indicating a proposal of a setting (hereinafter, often referred to as "first notification setting") for the processor 11 to detect and provide notification of completion of the charging of the battery 13. When the first notification setting is performed on the mobile terminal device 1 according to the display of the proposal on the notification setting screen SC1, the user is allowed to take a measure to reduce the damage on the battery 13 caused by the first cause, when the notification according to the first notification setting is made.

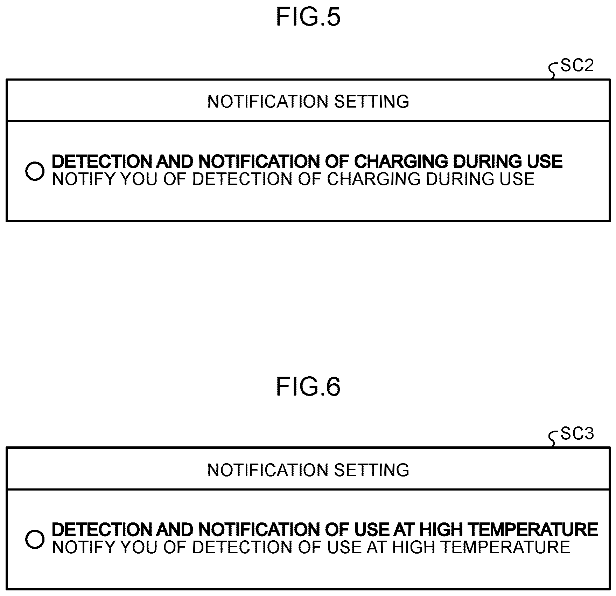

In addition, for example, when detecting that the second cause display is touched on the battery state transition screen SB, the processor 11 performs transition of screens to be displayed on the display unit 14 to a notification setting screen SC2 as illustrated in FIG. 5, from the battery state transition screen SB. FIG. 5 is a diagram illustrating an example of the notification setting screen according to the first embodiment of the present disclosure. The notification setting screen SC2 illustrated in FIG. 5 includes a display indicating a proposal of a setting (hereinafter, often referred to as "second notification setting") for the processor 11 to detect and provide notification of charging of the battery 13 during use of the mobile terminal device 1. When the second notification setting is performed on the mobile terminal device 1 according to the display of the proposal on the notification setting screen SC2, the user is allowed to take a measure to reduce the damage on the battery 13 caused by the second cause, when the notification according to the second notification setting is made.

In addition, for example, when detecting that the third cause display is touched on the battery state transition screen SB, the processor 11 performs transition of screens to be displayed on the display unit 14 to a notification setting screen SC3 as illustrated in FIG. 6, from the battery state transition screen SB. FIG. 6 is a diagram illustrating an example of the notification setting screen according to the first embodiment of the present disclosure. The notification setting screen SC3 illustrated in FIG. 6 includes a display indicating a proposal of a setting (hereinafter, often referred to as "third notification setting") for the processor 11 to detect and provide notification of the terminal temperature equal to or larger than the threshold THA. When the third notification setting is performed on the mobile terminal device 1 according to the display of the proposal on the notification setting screen SC3, the user is allowed to take a measure to reduce the damage on the battery 13 caused by the third cause, when the notification according to the third notification setting is made.

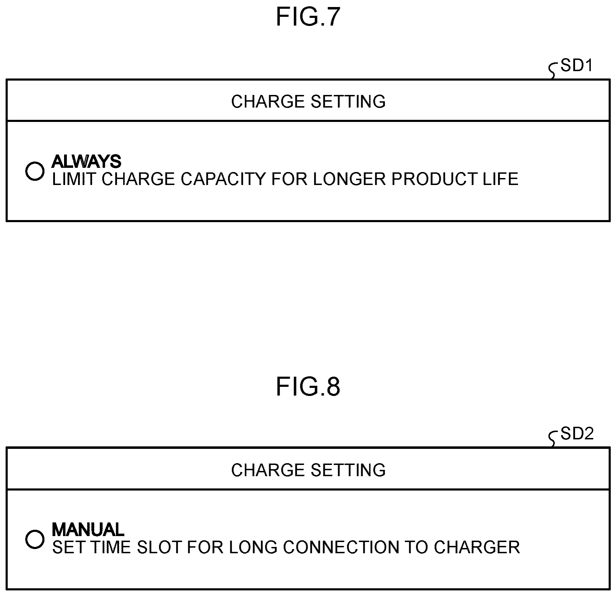

In addition, for example, when detecting that the first cause display is touched on the battery state transition screen SB and when a duration of the first cause is equal to or larger than a threshold THB, the processor 11 performs transition of screens to be displayed on the display unit 14 to a charge setting screen SD1 as illustrated in FIG. 7, from the battery state transition screen SB. FIG. 7 is a diagram illustrating an example of the charge setting screen according to the first embodiment of the present disclosure. The charge setting screen SD1 illustrated in FIG. 7 includes a display indicating a proposal of a setting (hereinafter, often referred to as "first charge setting") for limiting an amount of charge in the battery 13. When the first charge setting is performed on the mobile terminal device 1 according to the display of the proposal on the charge setting screen SD1, a maximum amount of charge in the battery 13 is allowed to be limited to less than the full charge, thus reducing the damage on the battery 13 caused by the first cause.

In addition, for example, when detecting that the second cause display is touched on the battery state transition screen SB and when a duration of the second cause is equal to or larger than a threshold THC, the processor 11 performs transition of screens to be displayed on the display unit 14 to a charge setting screen SD2 as illustrated in FIG. 8, from the battery state transition screen SB. FIG. 8 is a diagram illustrating an example of the charge setting screen according to the first embodiment of the present disclosure. The charge setting screen SD2 illustrated in FIG. 8 includes a display indicating a proposal of a setting (hereinafter, often referred to as "second charge setting") for specifying a time slot in which the battery 13 is charged. When the second charge setting is performed on the mobile terminal device 1 according to the display of the proposal on the charge setting screen SD2, it is possible to reduce the frequency of the "charging during use" unintentionally performed by the user, thus reducing the damage on the battery 13 caused by the second cause.

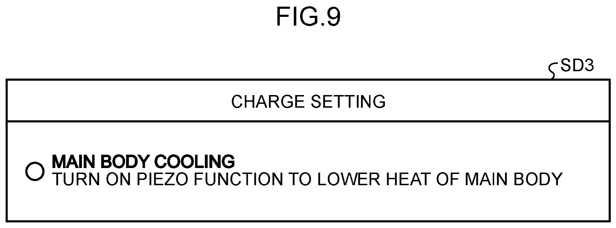

In addition, for example, when detecting that the third cause display is touched on the battery state transition screen SB and when a duration of the third cause is equal to or larger than a threshold THD, the processor 11 performs transition of screens to be displayed on the display unit 14 to a charge setting screen SD3 as illustrated in FIG. 9, from the battery state transition screen SB. FIG. 9 is a diagram illustrating an example of the charge setting screen according to the first embodiment of the present disclosure. The charge setting screen SD3 illustrated in FIG. 9 includes a display indicating a proposal of a setting (hereinafter, often referred to as "cooling setting") for the processor 11 to operate the cooling unit 17. When the cooling setting is performed on the mobile terminal device 1 according to the display of the proposal on the charge setting screen SD3, it is possible to suppress the rise in the terminal temperature and the battery temperature, thus reducing the damage on the battery 13 caused by the third cause.

In the above, the example of use of the touch screen for the display unit 14 to select each of the displays by touching has been described. In contrast, instead of the touch screen, a display may be used for the display unit 14. When the display is used for the display unit 14, each of the display is selected by a pointer that moves according to an operation of a pointing device connected to the mobile terminal device 1.

The first embodiment has been described above.

### [Second Embodiment]

Each process in the above description in the processor 11 may be implemented by causing the processor 11 to execute a program corresponding to each process. For example, the program corresponding to each process in the above description may be stored in the memory 12 so that the program is read from the memory 12 and executed by the processor 11. In addition, the program may be stored in a program server connected to the mobile terminal device 1 via any network, downloaded from the program server to the mobile terminal device 1 for execution, or may be stored in a recording medium readable by the mobile terminal device 1, and read from the recording medium for execution. Examples of the recording medium readable by the mobile terminal device 1 include portable storage media, such as a memory card, USB memory, SD card, flexible disk, magnetooptical disk, CD-ROM, DVD, and a Blu-ray (registered trademark) disk. In addition, the program may be written in any language or by any writing method, regardless of a form such as a source code, binary code, or the like. In addition, the program is not necessarily limited to a single program, and also includes programs distributed into a plurality of modules or a plurality of libraries, and a program implementing the function thereof in cooperation with a separate program represented by an OS.

The second embodiment has been described above.

### [Effects of disclosed techniques]

As described above, the mobile terminal device of the present disclosure (the mobile terminal device 1 of the embodiments) includes the battery (the battery 13 of the embodiments), the display unit (the display unit 14 of the embodiments), and the processor (the processor 11 of the embodiments). The processor causes the display unit to display a first display (display of damage of the embodiments) indicating the use having caused damage to the battery. Furthermore, when the first display is selected, the processor causes the display unit to display a second display (damage cause display of the embodiments) indicating a cause of the damage given to the battery. Furthermore, when the second display is selected, the processor causes the display unit to display a third display indicating a proposal of a setting (the first notification setting, second notification setting, third notification setting, first charge setting, second charge setting, or third charge setting of the embodiments) for reducing the damage given to the battery.

For example, the processor causes the display unit to display the first display per day, over a plurality of days, and causes the display unit to display the second display in association with the time slot in which the battery is damaged, for the day for which the first display is selected from among the plurality of days.

In addition, for example, the cause of the damage given to the battery includes the first cause that the battery has been left in the full charge state, and when the display indicating the first cause is selected, the processor causes the display unit to display the display (FIG. 4 of the embodiment) indicating the proposal of the setting for detecting and providing notification of completion of the charging of the battery. In addition, for example, when the display indicating the first cause is selected and the duration of the first cause is equal to or larger than the threshold, the processor causes the display unit to display the display (FIG. 7 of the embodiment) indicating the proposal of the setting for limiting the amount of charge in the battery.

In addition, for example, the cause of the damage given to the battery includes the second cause that the battery has been charged during use of the mobile terminal device, and when the display indicating the second cause is selected, the processor causes the display unit to display the display (FIG. 5 of the embodiment) indicating the proposal of the setting for detecting and providing notification of charging of the battery during use of the mobile terminal. In addition, for example, when the display indicating the second cause is selected and the duration of the second cause is equal to or larger than the threshold, the processor causes the display unit to display the display (FIG. 8 of the embodiment) indicating the proposal of the setting for specifying the time slot in which the battery is charged.

In addition, for example, the cause of the damage given to the battery includes the third cause that the mobile terminal device has been used while the terminal temperature is equal to or larger than the threshold, and when the display indicating the third cause is selected, the processor causes the display unit to display the display (FIG. 6 of the embodiment) indicating the proposal of the setting for detecting and providing notification of the terminal temperature equal to or larger than the threshold. In addition, for example, when the display indicating the third cause is selected and the duration of the third cause is equal to or larger than the threshold, the processor causes the display unit to display the display (FIG. 9 of the embodiment) indicating the proposal of the setting for operating the cooling unit that cools the mobile terminal device.

The configuration as described above enables the user of the mobile terminal device to recognize what kind of use causes the damage to the battery, and therefore, the deterioration of the battery mounted on the mobile terminal device can be suppressed by the setting from the user.

Note that the effects described herein are merely examples, and the present disclosure is not limited to these effects and may have other effects.

Furthermore, the disclosed technique can also have the following configurations.
(1) A mobile terminal device comprising a battery, a display unit, and a processor,
   wherein the processor
   causes the display unit to display a first display indicating a use having caused damage to the battery,
   causes the display unit to display a second display indicating a cause of the damage given to the battery, when the first display is selected, and
   causes the display unit to display a third display indicating a proposal of a setting for reducing the damage given to the battery, when the second display is selected.
(2) The mobile terminal device according to (1), wherein
   the processor
   causes the display unit to display the first display per day over a plurality of days, and
   causes the display unit to display the second display in association with a time slot in which the battery is damaged, for a day for which the first display is selected from among the plurality of days.
(3) The mobile terminal device according to (1) or (2), wherein
   the cause includes a first cause that the battery has been left in a full charge state, and
   the processor causes the display unit to display the third display indicating a proposal of a setting for detecting and providing notification of completion of charging of the battery, when the second display indicating the first cause is selected.
(4) The mobile terminal device according to (1) or (2), wherein
   the cause includes a second cause that the battery being charged during use of the mobile terminal device, and
   the processor causes the display unit to display the third display indicating a proposal of a setting for detecting and providing notification of charging of the battery during use of the mobile terminal device, when the second display indicating the second cause is selected.
(5) The mobile terminal device according to (1), further comprising
   a sensor that detects a temperature of the mobile terminal device,
   wherein the cause includes a third cause that the mobile terminal device has been used while the temperature is equal to or larger than a threshold, and
   when the second display indicating the third cause is selected, the processor causes the display unit to display the third display indicating a proposal of a setting for detecting and providing notification of the temperature equal to or larger than the threshold.
(6) The mobile terminal device according to (1) or (2), wherein
   the cause includes a first cause that the battery has been left in a full charge state, and
   the processor causes the display unit to display the third display indicating a proposal of a setting for limiting an amount of charge in the battery when the second display indicating the first cause is selected and a duration of the first cause is equal to or larger than a threshold.
(7) The mobile terminal device according to (1) or (2), wherein
   the cause includes a second cause that the battery being charged during use of the mobile terminal device, and
   the processor causes the display unit to display the third display indicating a proposal of a setting for specifying a time slot in which the battery is charged when the second display indicating the second cause is selected and a duration of the second cause is equal to or larger than a threshold.
(8) The mobile terminal device according to (1) or (2), further comprising:
   a sensor that detects a temperature of the mobile terminal device; and
   a cooling unit that cools the mobile terminal device;
   wherein the cause includes a third cause that the mobile terminal device has been used while the temperature is equal to or larger than a threshold, and
   the processor causes the display unit to display the third display indicating a proposal of a setting for operating the cooling unit when the second display indicating the third cause is selected and a duration of the third cause is equal to or larger than a threshold.
(9) A proposal display method in a mobile terminal device including a battery, a display unit, and a processor, the method executed by the processor comprising:
   causing the display unit to display a first display indicating a use having caused damage to the battery;
   causing the display unit to display a second display indicating a cause of the damage to the battery, when the first display is selected; and
   causing the display unit to display a third display indicating a proposal of a setting for reducing the damage given to the battery, when the second display is selected.
(10) A program usable for a mobile terminal device including a battery, a display unit, and a processor, the program causing the processor to execute a process, comprising:
   causing the display unit to display a first display indicating a use having caused damage to the battery;
   causing the display unit to display a second display indicating a cause of the damage to the battery, when the first display is selected; and
   causing the display unit to display a third display indicating a proposal of a setting for reducing the damage given to the battery, when the second display is selected.

### Reference Signs List

- 1: MOBILE TERMINAL DEVICE

- 11: PROCESSOR
- 12: MEMORY
- 13: BATTERY
- 14: DISPLAY UNIT
- 15: WIRELESS COMMUNICATION MODULE
- 16: TEMPERATURE SENSOR
- 17: COOLING UNIT

## Claims

1. A mobile terminal device comprising a battery, a display unit, and a processor,
wherein the processor
causes the display unit to display a first display indicating a use having caused damage to the battery,
causes the display unit to display a second display indicating a cause of the damage given to the battery, when the first display is selected, and
causes the display unit to display a third display indicating a proposal of a setting for reducing the damage given to the battery, when the second display is selected.

2. The mobile terminal device according to claim 1, wherein
the processor
causes the display unit to display the first display per day over a plurality of days, and
causes the display unit to display the second display in association with a time slot in which the battery is damaged, for a day for which the first display is selected from among the plurality of days.

3. The mobile terminal device according to claim 1, wherein
the cause includes a first cause that the battery has been left in a full charge state, and
the processor causes the display unit to display the third display indicating a proposal of a setting for detecting and providing notification of completion of charging of the battery, when the second display indicating the first cause is selected.

4. The mobile terminal device according to claim 1, wherein
the cause includes a second cause that the battery being charged during use of the mobile terminal device, and
the processor causes the display unit to display the third display indicating a proposal of a setting for detecting and providing notification of charging of the battery during use of the mobile terminal device, when the second display indicating the second cause is selected.

5. The mobile terminal device according to claim 1, further comprising
a sensor that detects a temperature of the mobile terminal device,
wherein the cause includes a third cause that the mobile terminal device has been used while the temperature is equal to or larger than a threshold, and
when the second display indicating the third cause is selected, the processor causes the display unit to display the third display indicating a proposal of a setting for detecting and providing notification of the temperature equal to or larger than the threshold.

6. The mobile terminal device according to claim 1, wherein
the cause includes a first cause that the battery has been left in a full charge state, and
the processor causes the display unit to display the third display indicating a proposal of a setting for limiting an amount of charge in the battery when the second display indicating the first cause is selected and a duration of the first cause is equal to or larger than a threshold.

7. The mobile terminal device according to claim 1, wherein
the cause includes a second cause that the battery being charged during use of the mobile terminal device, and
the processor causes the display unit to display the third display indicating a proposal of a setting for specifying a time slot in which the battery is charged when the second display indicating the second cause is selected and a duration of the second cause is equal to or larger than a threshold.

8. The mobile terminal device according to claim 1, further comprising:
a sensor that detects a temperature of the mobile terminal device; and
a cooling unit that cools the mobile terminal device;
wherein the cause includes a third cause that the mobile terminal device has been used while the temperature is equal to or larger than a threshold, and
the processor causes the display unit to display the third display indicating a proposal of a setting for operating the cooling unit when the second display indicating the third cause is selected and a duration of the third cause is equal to or larger than a threshold.

9. A proposal display method in a mobile terminal device including a battery, a display unit, and a processor, the method executed by the processor comprising:
causing the display unit to display a first display indicating a use having caused damage to the battery;
causing the display unit to display a second display indicating a cause of the damage to the battery, when the first display is selected; and
causing the display unit to display a third display indicating a proposal of a setting for reducing the damage given to the battery, when the second display is selected.

10. A program usable for a mobile terminal device including a battery, a display unit, and a processor, the program causing the processor to execute a process, comprising:
causing the display unit to display a first display indicating a use having caused damage to the battery;
causing the display unit to display a second display indicating a cause of the damage to the battery, when the first display is selected; and
causing the display unit to display a third display indicating a proposal of a setting for reducing the damage given to the battery, when the second display is selected.
